# EUROPEAN PATENT SPECIFICATION

(11) **EP 0 295 097 B1**
(45) Date of publication and mention of the grant of the patent: **18.11.1993**
(21) Application number: 88305272.2
(22) Date of filing: 09.06.1988
(51) Int. Cl.: H01L 21/265, H01L 29/743

(54) **Fabricating a semiconductor structure**
Herstellung einer Halbleiterstruktur
Fabrication d'une structure semi-conductrice

(30) Priority: 11.06.1987 US 61754
(43) Date of publication of application: 14.12.1988
(73) Proprietor: FAIRCHILD SEMICONDUCTOR CORPORATION, Santa Clara California 95052 (US)
(72) Inventor: Akcasu, Osman Ersed, Chippewa Falls Wisconsin 54729 (US)
(74) Representative: Jones, Ian

(56) References cited:
- FR-A- 2 358 748
- PATENT ABSTRACTS OF JAPAN, vol. 6, no. 132 (E-119)[1010], 17th July 1982; & JP-A-57 58 352
- IBM TECHNICAL DISCLOSURE BULLETIN, vol. 21, no. 4, September 1978, pages 1554-1557, New York, US; R.F. BARTHOLOMEW et al.: "High performance NPN with low resistance base contact self-aligned to the emitter"

## Description

This invention relates to a method of fabricating a semiconductor structure, for example, a silicon-controlled rectifier structure.

A silicon-controlled rectifier ("SCR") is also known as a reverse-blocking triode thyristor. SCRs or thyristors are triggered into conduction in only one direction, from anode to cathode, by a pulse of control current. Once activated, the SCR continues to conduct current whether or not the pulse remains present. Like transistors, SCRs have two terminals for working current and one terminal for control current. Unlike transistors, however, SCRs do not require any further control current once they are turned on. When off, the SCR normally blocks current attempting to pass either way between the anode and cathode of the device. As a result of their unique functionality, SCRs are widely applied in programmable read-only memories (PROMs) to blow fuses, as well as in motor control systems, solid state automobile ignition systems and elsewhere.

A lateral silicon-controlled rectifier structure implemented in integrated circuit form can be viewed as an PNPN structure in which a lateral NPN transistor is merged with a lateral PNP transistor. That is, the PNP base also serves as the NPN collector and the NPN base also serves as the PNP collector. Because of the need to form buried contacts to some of the regions, and because of the use of a P conductivity type wafer and N conductivity type epitaxia layer, the lateral SCR structure will include parasitic vertical transistors. For example, the N-type emitter of the lateral NPN transistor will also function vertically, using those portions of the P-type base beneath the emitter and an underlying N-type buried layer to form a parasitic NPN device. Similarly, a parasitic PNP device also will be formed.

In conventional non-self-aligned SCR structures, the lateral NPN base width of the device will be on the order of 2 to 3 microns (micrometers). This wide lateral base and associated high Gummel number make the gain of the lateral NPN device very low. Accordingly, it contributes little to active SCR operation, in contrast with the vertical NPN device. Furthermore, the lateral NPN device will not contribute significantly to carrying current in the transport because of the substantial amount of stored charge in and underlying the lateral NPN base region. To turn the SCR on, that stored charge must be supplied or removed. Because device switching speed is proportional to the stored charge difference between the on and off states, the resulting devices operate undesirably slowly.

Reference may be made to FR-A-2 358 748 which discloses the use of three successive insulating layers provided on the semiconductor surface. Various openings are formed, along with assorted masking and implementation steps to form a bipolar transistor along with a resistor in the same substrate.

The invention provides a method of fabricating a lateral silicon-controlled rectifier semiconductor structure comprising the steps of using a semiconductor substrate including an upper region of first conductivity type disposed on a lower region of opposite conductivity type;
forming a first insulating layer of first thickness on a semiconductor substrate;
forming a first impurity mask on the first insulating layer over a first region of the substrate;
removing at least part of the first insulating layer disposed over a second region of the substrate adjacent the first region;
providing electrical connections to the second region, and to a third region, and a fourth region,
characterised in that opposite conductivity type impurity is introduced into the substrate only in regions not overlaid by the impurity mask to form third and fourth regions spatially separated one from the other by first conductivity type impurity, and then
introducing first conductivity type impurity into the substrate through the second region.

In another aspect the invention provides a method of fabricating a self-aligned lateral silicon-controlled rectifier circuit comprising the steps of:
forming a first layer on a semiconductor substrate which include an underlying P conductivity type region and an overlying N conductivity type region;
forming a masking layer on the first layer over a first region of the substrate;
removing at least part of the layer from over a second and third region of the substrate, the second and third regions being separated by the first region; and
forming electrical connections (43,41,45) to the second region, and to a third region, and to a fourth region,
characterised by introducing P conductivity type impurity into the substrate over the third region and a fourth region surrounding the second region;
introducing N conductivity type impurity into the substrate over the second region.

The method of the invention can be applied to the fabrication of a silicon-controlled rectifier structure in which the width of the base region of a lateral NPN device is substantially reduced. The invention can thus permit reduction of the volume of the region of stored charge beneath the lateral NPN base by a factor of about ten in comparison with prior art structures. This makes the lateral NPN base width and the Gummel number on the same order of magnitude as the associated vertical NPN device. Thus, the gain and reverse saturation current density of both devices is approximately the same, thereby introducing the lateral NPN device into active device operation, which reduces the stored charge still further for the same operating current conditions. In addition, the invention makes it possible to increase packing density substantially to reduce base-collector capacitance, and to reduce parasitic resistance.

In one embodiment, the method of the invention comprises fabricating a self-aligned lateral silicon-controlled rectifier and by forming the insulating layer on a substrate which includes an upper N conductivity type region and a lower P conductivity type region; forming the impurity mask on the insulating layer over the first region of the substrate; removing at least part of the insulating layer from the second region of the substrate adjacent the first region; introducing P conductivity type impurity into the substrate through the second region to thereby form an NPN emitter region; and providing the electrical connections to the NPN emitter and base and to the PNP injector.

In other embodiments of the invention, a static random access memory cell is fabricated in which the lateral NPN base width is substantially reduced. In yet another embodiment, the buried collector is doubly doped.

The invention is further described below, by way of example, with reference to the accompanying drawings, in which:
Figure 1 is a cross-sectional view of a semiconductor structure illustrating formation of a first impurity mask,
Figure 2 is a subsequent cross-sectional view after removal of a first insulating layer from regions adjacent the impurity mask and partial reformation thereof,
Figure 3 is a subsequent cross-sectional view after introduction of P-type dopant for the NPN base and PNP injector,
Figure 4 is a subsequent cross-sectional view after introduction of N-type dopant for the NPN emitter,
Figure 5 is a subsequent cross-sectional view after annealing of the structure and diffusion of the impurities introduced,
Figure 6 is a subsequent cross-sectional view after formation of electrical contacts,
Figure 7 is a circuit schematic illustrating the circuit formed by the structure of Figure 6,
Figure 8 illustrates a portion of a static random access memory cell fabricated using the process of Figures 1-6,
Figure 9 illustrates an alternative embodiment of Figure 8 in which the NPN base is deeply diffused, and
Figure 10 illustrates another alternative embodiment in which portions of the buried layer are doubly implanted.

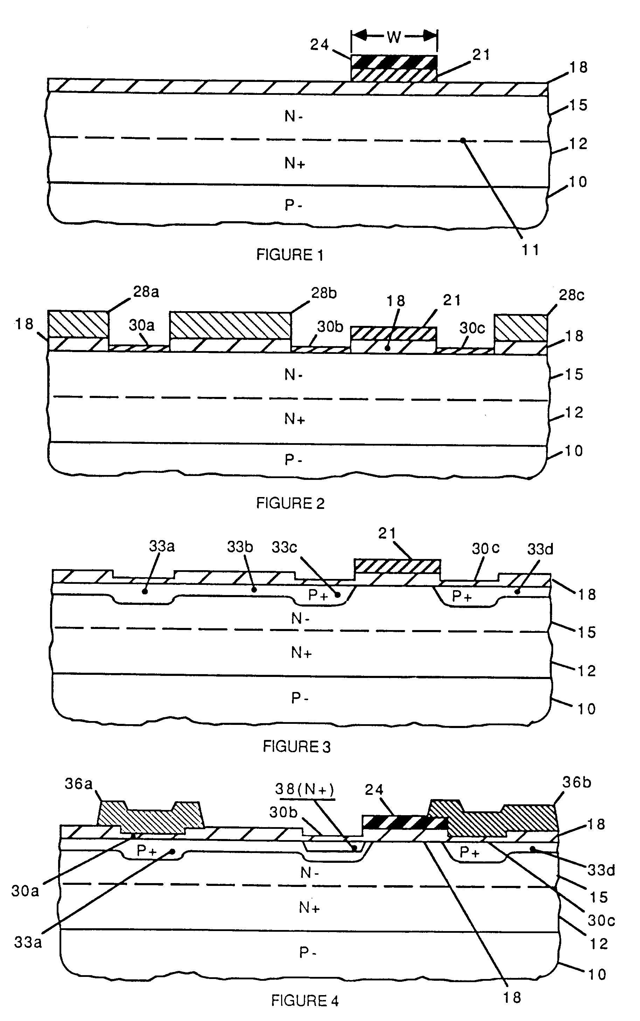

Figure 1 is a cross-sectional view of a semiconductor structure which may be fabricated using well known technology. For example, in a preferred embodiment the process begins with a silicon wafer 10 doped with P-type impurity to a resistivity on the order 10-20 ohm-centimeters. Then using well-known ion-implantation techniques, an N conductivity type impurity is implanted into the upper surface 11 of the wafer 10 to form a heavily doped N+ region 12 which will function as a buried collector for the vertical NPN device, as well as a base for the vertical PNP device, in other words, the parasitic vertical substrate PNP transistor. In the preferred embodiment, region 12 is doped with arsenic to a concentration of approximately 1-3x10¹⁹ atoms per cubic centimeter at the epi-substrate interface before the epi deposition, and a junction depth of approximately 1-2 microns after the entire process is completed. This gives low enough sheet resistivity to minimize the lateral component of the collector resistance and to reduce the parasitic vertical PNP current gain to an acceptable level. Then, employing conventional semiconductor fabrication technology, an epitaxial layer 15 is formed across the upper surface of the structure. Layer 15 will be about 1-1.5 microns thick, and will have an impurity concentration of approximately 1-2x10¹⁶ atoms per cubic centimeter of arsenic or phosphorus.

Next, and not shown in the figures, suitable isolation regions are formed to create islands of semiconductor material in which active devices will be formed. This is achieved, in the preferred embodiment, by forming regions of oxidized silicon which extend into the structure to the PN junction between regions 10 and 12. By forming these regions of silicon dioxide in an annular shape (as viewed from above), electrically isolated pockets of silicon are created. Figure 1 is a cross-sectional view of one such pocket, but does not show the oxide isolation regions. Such epitaxial pockets of silicon may be fabricated using any well known oxide isolation process, for example, as described by Douglas Peltzer in U.S. Patent 3,648,125 entitled "Method of Fabricating Integrated Circuits with Oxidized Isolation and the Resulting Structure." Of course, other isolation techniques such as guard rings may also be employed. As will become evident, the process of the invention does not require any particular isolation technology to be employed in place of any other.

At the completion of the isolation process, a layer of silicon dioxide 18 is formed on the upper surface of epitaxial layer 15 using a suitable thermal process. In the preferred embodiment silicon dioxide 18 is 1500-2500 Angstroms (10 Angstroms = 1 nm) thick. The thickness of the silicon dioxide 18 is determined by various considerations. First, it should be at least five to ten times thicker than the screen oxide 30 to allow a self-aligned contact opening using a short etch (dip) in HF before metallization. It should be also thick enough to mask the arsenic implant for self-aligned p-n junction definitions. It should also be thin enough not to mask the boron implants which are used to define the P regions in the structure. In the process, the oxide thickness which is used is 1750 Angstroms.

Next, a layer of silicon nitride 21 is formed across the upper surface of silicon dioxide 18. The thickness of the silicon nitride will be determined by the energy used for a subsequent boron implant (or vice versa). As described below in conjunction with Figure 3, the combined thicknesses of silicon dioxide 18 and silicon nitride 21 mask a boron implant. Thus, the combined thickness of the two layers must be such as to prevent boron from entering epitaxial layer 15. For example, if 100 keV implant energy is employed, a combined thickness of about 0.3 microns will suffice. Alternatively, if 200 keV is employed, then a combined thickness of 0.6 microns is required. After formation of silicon nitride layer 21, another layer of silicon dioxide 24 is deposited across the upper surface of nitride 21.

Using conventional techniques, silicon dioxide 24 is patterned into a desired region, such as the small region depicted in Figure 1. Such conventional techniques typically will include formation of a layer of photoresist over silicon dioxide 24, exposure of the photoresist through a mask, and etching of layer 24 using a well known wet (chemical) or dry (plasma) process which attacks silicon dioxide 24 but not silicon nitride 21. As will be explained below, the width W of silicon dioxide 24 determines the width of the base of the lateral PNP device. Accordingly, in the preferred embodiment a width W on the order of 1.5-1.6 microns is employed. This width will make the lateral PNP base width substantially less than 1 micron.

After definition of silicon dioxide 24, the thereby-exposed regions of the layer of silicon nitride 21 are etched, this time employing a wet or dry process which attacks silicon nitride but not silicon dioxide. In the preferred embodiment, plasma etching is employed to carry out this process. At the completion of the etching of silicon nitride 21, the appearance of the structure is as depicted in Figure 1.

Figure 2 illustrates the next stages of the process of the invention. A layer of photoresist 28 is deposited across the upper surface of the structure and defined into regions 28a, 28b, and 28c. These photoresist regions serve to protect silicon dioxide 18 wherever electrical contacts to the substrate are not desired. Additionally, photoresist layer 28 will be removed from any region of the substrate where it is desired to implant P conductivity type impurity more deeply than in other regions.

After the photoresist 28 is defined into the desired pattern, again using well known photolithographic techniques, the exposed portions of silicon dioxide 18 between the regions of photoresist 28 are etched, again using any well known wet or dry process. In the preferred embodiment, plasma etching is employed for this process. During this etching, the silicon dioxide cap 24 on silicon nitride mask 21 also will be removed. The etching process may be achieved using either of two techniques. In the preferred embodiment, it is carried out for a period of time sufficient to completely remove silicon dioxide from the surface of the substrate 15 in the regions unprotected by photoresist 28. Then a new thinner layer of silicon dioxide 30 is formed in the openings. In the preferred embodiment silicon dioxide 30 is approximately 100-250 Angstroms thick and formed by heating the structure in an oxidizing ambient. This step is required to create a self-aligned metal contact, and to prevent out-gasing of the impurities from these contact windows. The oxide thickness is thin enough not to mask the impurities which will be introduced into silicon by implantation. The oxide 30 is also thick enough to prevent out-gasing of the impurities in the anneal cycle. These oxide properties also are known as "screen oxide" properties. Screen oxide 30 prevents the undesired effects of implantation directly into bare silicon. As a result, for 60KeV arsenic implants for the N regions below the contact openings, the oxide thickness should be less than 250 Angstroms.

In an alternative embodiment the etching of the layer 18 is performed for a shorter period of time to leave the relatively thinner regions of silicon dioxide in the regions unprotected by photoresist 28. At the completion of either process, the appearance of the structure is as depicted in Figure 2.

The photoresist 28 then is removed from the structure and boron ions implanted, using well known ion-implantation techniques. The boron is implanted with sufficient energy to penetrate the differing thicknesses of silicon dioxide 18 and 30, but not with sufficient energy to penetrate the combined thickness of silicon dioxide 18 and silicon nitride 21. As mentioned above, the energy required will depend upon the thickness of the silicon dioxide and silicon nitride. In the preferred embodiment, we employ two boron implants with different dose and energies, to achieve lower vertical NPN Gummel numbers as well as maintain low extrinsic base and contact resistances. Dosage and energies used are 8x10¹² cm⁻², 120KeV and 1.45x10¹⁴ cm⁻², 50KeV for intrinsic and extrinsic base implants, respectively. As a result of this process, heavily doped P-type regions 33 are formed in epitaxial layer 15 adjacent its upper surface. Where the silicon dioxide 18 is thicker, the boron atoms do not penetrate as far into the epitaxial layer 15, and consequently shallower regions of boron impurity such as regions 33b and 33d are formed. Where the silicon dioxide is thinner than the original thickness, the boron will penetrate more deeply into the epitaxial layer and form regions such as 33a and 33c. The importance of these deeper regions is discussed below. After implanting the boron, the appearance of the structure is as depicted in Figure 3.

An emitter mask 36 then is formed across the surface of the structure to protect the thinner regions of silicon dioxide 30a and 30c where emitters for the NPN devices are not desired. Once mask 36 is suitably patterned, again using well known photolithographic techniques, arsenic or other suitable N conductivity type impurity is implanted into the epitaxial layer 15 through the thin region of silicon dioxide 30b to form an emitter region 38. Region 38 is doped with arsenic to a concentration of 1-2x10²⁰ cm⁻³ giving 0.2-0.25 microns of junction depth after the process is completed. To achieve this we use an arsenic implantation with a dose and energy of 10¹⁶ cm⁻² and 60KeV, respectively. The N⁺ regions formed as explained will give high emitter injection efficiency and low contact resistance. The appearance of the structure at this stage of the process is shown in Figure 4.

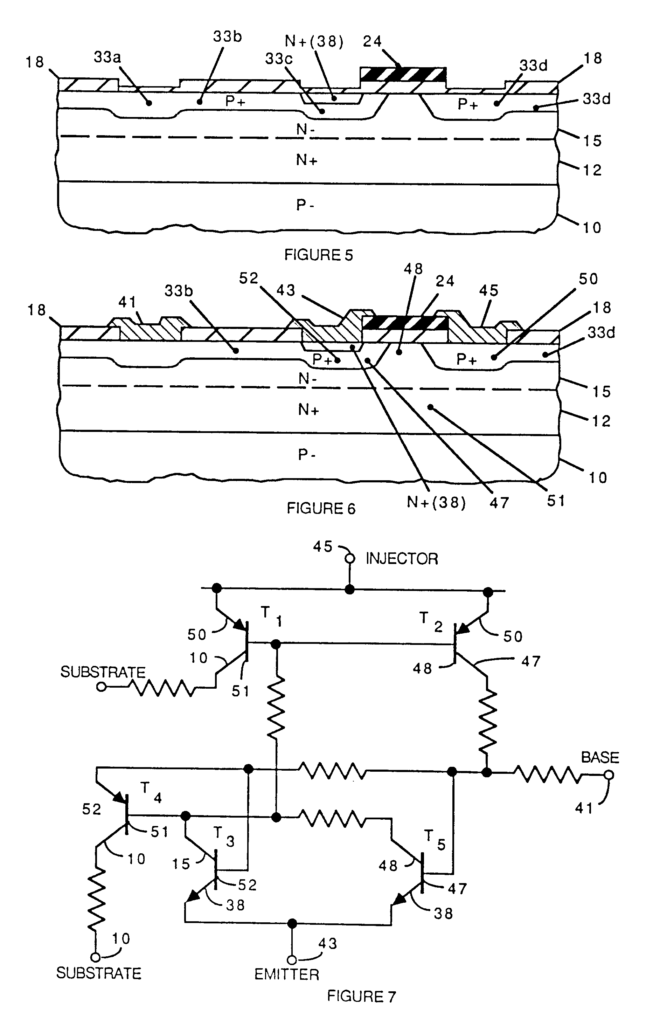

The structure is then placed in a furnace and heated to 1000°C for 40 minutes to anneal the damage caused by the implantation, and thereby reorder the monocrystalline silicon 15. As shown in Figure 5, during this process the impurity implanted to form the P and N conductivity type regions 33 and 38 will diffuse further out into the epitaxial silicon 15. Importantly, because of the higher diffusivity of boron over arsenic, the P-type region 33c will diffuse further under the mask of silicon nitride 24, than will N-type region 38. At the same time the P-type impurity 33d will also diffuse beneath nitride 24, thereby narrowing the base width of the lateral PNP device to well less than 1 micron. The appearance of the structure following annealing is shown in Figure 5.

Figure 6 is a cross section of the completed structure. Following the annealing, ohmic contacts may be fabricated to the surface of the desired regions using any well known technique. For example, silicon dioxide 18 may be masked and openings formed therein to expose the upper surface of the NPN base region 33b, the NPN emitter region 38, and the PNP injector region 33d. Alternatively, and depending upon the relative thicknesses of the thinner and thicker portions of silicon dioxide 18, the structure may be dipped in an etching solution for a sufficiently short period of time to etch through the thin regions of layer 18, but not the thick ones. Then a layer of aluminum is deposited and defined into contacts 41, 43, and 45 to provide electrical connections to the desired regions. In another embodiment, electrically conductive material, such as a silicide compound, is deposited across the integrated circuit and defined into contacts as shown in Figure 6.

In Figure 6 additional reference numerals have been added to designate the various functional portions of the structure. For example, the lateral NPN base 47, the lateral PNP base 48, the vertical PNP base 51, and the vertical NPN base 52 are designated.

Figure 7 is a simplified equivalent circuit of the silicon-controlled rectifier structure shown in Figure 6 with corresponding regions of the structure and portions of the schematic being given the same reference numerals. Transistor T₂ is the lateral PNP device having injector 50, base 48, and collector 47. Transistor T₅ is the lateral NPN device having emitter 38, base 47, and collector 48. Transistor T₃ is the vertical NPN transistor formed by emitter 38, base 52, and collector 15, while transistors T₁ and T₄ are the parasitic substrate PNP transistors, with transistor T₁ having emitter 50, base 51, and collector 10, and transistor T₄ having emitter 52, base 51, and collector 10. Figure 7 also shows the various parasitic resistances.

In Figure 6 the lateral NPN base width 47 is substantially narrower than available with prior art techniques by virtue of the self-aligned nature of the process. In particular, while the starting base width is defined by a masking dimension, that is, width W in Figure 1, the ultimate base width may be made substantially narrower than this masking tolerance, with the ultimate base width depending upon the amount of impurity used to form the P-type regions, and the parameters of the annealing process during which the diffusion occurs. The self-alignment of the right edge of the emitter and the base regions with the left edge of the injector in the manner depicted in the figures creates a compact structure and substantially reduces the NPN base width. Because the stored charge beneath the lateral NPN base determines the switching time, the width is made as narrow as possible. By fabricating it in the manner described above, the volume of stored charge may be reduced by a factor of ten or more when compared to the prior art. Because the lateral NPN base width and the Gummel number is on the same order as the vertical NPN device (T₃), the gain and the reverse saturation current density of transistors T₅ and T₃ will be approximately the same, resulting in active device operation of transistor T₅.

In another embodiment of the invention, polycrystalline silicon is used in place of silicon nitride. The use of polysilicon is advantageous because it is significantly easier to form a thick enough mask which replaces the nitride 21 if higher energy boron implants are to be used in the process. Moreover, using polysilicon as a mask will enable incorporating polysilicon emitter structures in the process without major modifications.

The structure which results from the process of the invention may be employed in many applications, for example, in PROMs where high performance SCRs are required to blow the fuses. The structure of the invention reduces the stored charge by as much as 50% and reduces the cell length, while also lowering substrate injection and standby current. As a result, the device provides increased speed, higher performance, and better packing densities than currently-available SCRs.

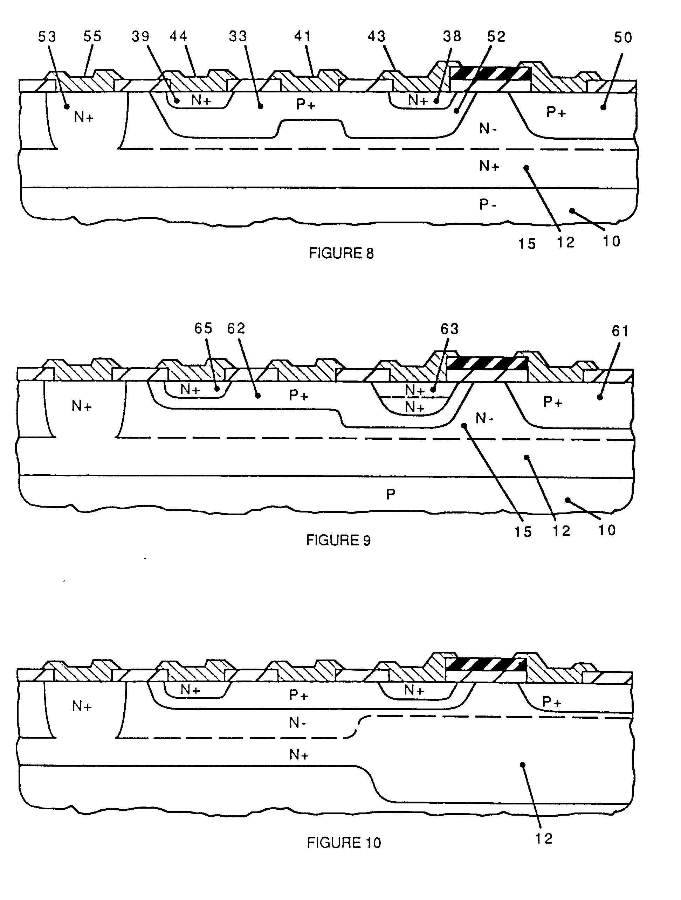

Figure 8 is a cross-sectional view of another structure which may be fabricated using the process of the invention. Figure 8 is one-half of a static random access memory cell. In practice a duplicate structure would be disposed nearby with commonly connected standby emitters 39 and injectors 50 and cross-coupled bases 33 and collectors 12. The structure of Figure 8 is fabricated in the same manner as the structure of Figure 6. The standby emitter 39 is introduced into P-type region 33 at the same time emitter 38 is formed. An electrical connection 44 is made to emitter 39 at the surface of the structure, while the NPN base contact 41 is disposed between the emitter contacts 43 and 44. Figure 8 also illustrates a collector contact 53 extending from an ohmic contact 55 on the surface to the buried collector region 12. This contact is formed after the oxide isolation but prior to Figure 1, in the manner described in the Peltzer patent.

Figure 9 is a cross-sectional view of an alternative embodiment of a random access memory cell which may be fabricated using the technique described above in conjunction with Figures 1-6. The structure of Figure 9 has been modified, however, in that more P-type dopant 60 and 61 has been introduced than in the previous process. The base 60 and injector region 61 are formed in the same manner as described in conjunction with Figures 1-6, but with implantation through larger openings. By extending the injector 61 even deeper in the manner depicted in Figure 8, the lateral injection efficiency of the injector is increased. In this manner the peripheral-area-to-floor-area ratio of the injector is increased and the injection efficiency of the floor is reduced by an order of magnitude. Reducing the injection efficiency of the floor reduces the substrate injection and injected hole charge in the subcollector and to the substrate substantially. Additionally, the emitter 63 is given additional dopant, or is doped with phosphorus while the standby emitter 65 is doped with arsenic. Driving the base diffusions down, almost to the buried layer, provides higher current gain and larger current drive for the lateral PNP device.

Figure 10 is a cross-sectional view of another semiconductor structure which may be fabricated using the process of the invention. In Figure 10, the lateral injection efficiency of the injector is increased by allowing a portion of the buried collector to up diffuse more than other portions. Because the floor injection efficiency is reduced by having larger donor concentration at the injector-buried layer junction, hole injection to the buried layer and to the substrate will be reduced. Additionally, the parasitic substrate PNP base Gummel number will be increased which will reduce substrate injection even more.

The structure shown in Figure 10 may be fabricated by implanting the buried layer 12 with arsenic or antimony in the conventional manner, and then also implanting phosphorus into those portions of the substrate where the buried layer 12 is desired to up diffuse in the manner depicted. Because phosphorus diffuses faster in silicon than arsenic or antimony, it will reach the injector in the base region adjacent the injector allowing the desired structure to be achieved.

The foregoing has been a description of preferred embodiments of the process of the invention. Although numerous details have been provided regarding the operation and fabrication of the structures depicted, these details have been provided for the purpose of illustration. The scope of the invention may be ascertained from the appended claims.

## Claims

1. A method of fabricating a lateral silicon-controlled rectifier semiconductor structure comprising the steps of using a semiconductor substrate including an upper region (12,15) of first conductivity type disposed on a lower region (10) of opposite conductivity type;
forming a first insulating layer (18) of first thickness on a semiconductor substrate;
forming a first impurity mask (21) on the first insulating layer over a first region of the substrate;
removing at least part of the first insulating layer (18) disposed over a second region of the substrate adjacent the first region;
providing electrical connections (43,41,45) to the second region, and to a third region, and a fourth region,
characterised in that opposite conductivity type impurity is introduced into the substrate only in regions not overlaid by the impurity mask (21) to form third and fourth regions (33;62) spatially separated one from the other by first conductivity type impurity, and then
introducing first conductivity type impurity into the substrate through the second region (38;63).

2. A method as claimed in claim 1 wherein the third region (33;62) is disposed to surround the second region (38;63).

3. A method as claimed in claim 2, wherein the removing step comprises removing at least part of the first thickness of the first insulating layer (18) over a selected part of the third region.

4. A method as claimed in claim 3, wherein the removing step comprises removing all of the first insulating layer (18) over the second region and all of the first insulating layer (10) over the selected part of the third region.

5. A method as claimed in claim 4 wherein the removing step comprises, after the step of removing all of the first insulating layer (18), the step of forming further insulating material over the second region and the selected part of the third region.

6. A method as claimed in claim 5 wherein the further insulating material is of second thickness less than the first thickness.

7. A method as claimed in any preceding claim wherein the removing step comprises removing at least part of the first thickness of the first insulating layer over a fifth region, the fifth region (39;65) being spaced apart from the second region (38) but also surrounded by the third region.

8. A method as claimed in claim 7 wherein the step of introducing first conductivity type impurity into the substrate comprises introducing the first conductivity type impurity through the fifth region (39;65).

9. A method as claimed in any preceding claim wherein the upper region of the substrate comprises a lower portion (12) more heavily doped than an upper portion (15).

10. A method as claimed in claim 9 wherein the third and the fourth regions extend into the upper portion (15) of the substrate and not into the lower portion (12).

11. A method as claimed in claim 9 or 10 wherein prior to the step of forming the first impurity mask, first conductivity type impurity is introduced into a sixth region of the substrate separated from both the third and fourth regions to form a connection (53) to the lower portion (12) of the substrate.

12. A method as claimed in any one of claims 1-8 comprising, prior to the step of forming the first insulating layer (18), the steps of:
introducing a selected first conductivity type impurity into an opposite conductivity type silicon wafer to form a buried layer (12); and
depositing a silicon layer (15) of first conductivity type on the silicon wafer to thereby form the substrate.

13. A method as claimed in claim 12 wherein the silicon layer (15) is less strongly doped with first conductivity type than the buried layer (12).

14. A method as claimed in claim 12 or 13 wherein the step of introducing a selected first conductivity type impurity further comprises introducing the selected impurity into all of the silicon wafer beneath the first, third and fourth regions.

15. A method as claimed in claim 14 comprising the step of introducing an additional first conductivity type impurity into the silicon wafer beneath at least the first and third regions.

16. A method as claimed in claim 15 wherein the additional first conductivity type impurity has a greater diffusivity in silicon than does the selected impurity.

17. A method as claimed in claim 16 wherein the selected impurity comprises arsenic and the additional impurity comprises phosphorus.

18. A method as claimed in any preceding claim wherein the substrate comprises silicon, the first insulating layer (18) comprises silicon dioxide, and the first impurity mask (21) comprises silicon nitride.

19. A method as claimed in any preceding claim wherein the first conductivity type is P.

20. A method of fabricating a self-aligned lateral silicon-controlled rectifier circuit comprising the steps of:
forming a first layer (18) on a semiconductor substrate which includes an underlying P conductivity type region (10) and an overlying N conductivity type region (12,15);
forming a masking layer (21) on the first layer over a first region of the substrate;
removing at least part of the layer (21) from over a second and a third region of the substrate, the second and third regions being separated by the first region; and
forming electrical connections (43,41,45) to the second region, and to a third region, and to a fourth region,
characterised by introducing P conductivity type impurity into the substrate over the third region and a fourth region surrounding the second region;
introducing N conductivity type impurity into the substrate over the second region.

21. A method as claimed in any preceding claim when used for fabricating a semiconductor structure for a static random access memory cell.

## Patentansprüche

1. Verfahren zur Herstellung einer lateralen Halbleiterstruktur für einen steuerbaren Siliziumgleichrichter, umfassend die folgenden Schritte: Verwenden eines Halbleitersubstrats mit einer oberen Zone (12, 15) eines ersten Leitfähigkeitstyps, der auf einer unteren Zone (10) des entgegengesetzten Leitfähigkeitstyps angeordnet ist;
Bilden einer ersten Isolationsschicht (18) einer ersten Dicke auf einem Halbleitersubstrat;
Bilden einer ersten Störstellenmaske (21) auf der ersten Isolationsschicht über einer ersten Zone des Substrats;
Entfernen wenigstens eines Teils der ersten Isolationsschicht (18), die sich über einer zweiten Zone des Substrats neben der ersten Zone befindet;
Vorsehen elektrischer Verbindungen (43, 41, 45) mit der zweiten Zone und mit einer dritten Zone und einer vierten Zone;
dadurch gekennzeichnet, daß die Störstelle des entgegengesetzten Leitfähigkeitstyps nur in Zonen in das Substrat eingebaut wird, die nicht durch die Störstellenmaske (21) überlagert sind, um eine dritte und vierte Zone (33, 62) zu bilden, die durch die Störstelle des ersten Leitfähigkeitstyps in einem räumlichen Abstand voneinander getrennt sind, und dann
Einbauen einer Störstelle des ersten Leitfähigkeitstyps in das Substrat durch die zweite Zone (38; 63).

2. Verfahren nach Anspruch 1, wobei die dritte Zone (33; 62) so angeordnet ist, daß sie die zweite Zone (38; 63) umgibt.

3. Verfahren nach Anspruch 2, wobei der Entfernungsschritt das Entfernen wenigstens eines Teils der ersten Dicke der ersten Isolationsschicht (18) über einem ausgewählten Teil der dritten Zone umfaßt.

4. Verfahren nach Anspruch 3, wobei der Entfernungsschritt das Entfernen der gesamten ersten Isolationsschicht (18) über der zweiten Zone und der gesamten ersten Isolationsschicht (10) über dem ausgewählten Teil der dritten Zone umfaßt.

5. Verfahren nach Anspruch 4, wobei der Entfernungsschritt umfaßt, daß nach dem Entfernen der gesamten ersten Isolationsschicht (18) weiteres Isolatormaterial über der zweiten Zone und dem ausgewählten Teil der dritten Zone gebildet wird.

6. Verfahren nach Anspruch 5, wobei das weitere Isolatormaterial eine zweite Dicke aufweist, die geringer ist als die erste Dicke.

7. Verfahren nach einem der vorhergehenden Ansprüche, wobei der Entfernungsschritt das Entfernen wenigstens eines Teils der ersten Dicke der ersten Isolationsschicht über einer fünften Zone umfaßt, wobei die fünfte Zone (39; 65) einen Abstand von der zweiten Zone (38) hat, aber auch von der dritten Zone umgeben ist.

8. Verfahren nach Anspruch 7, wobei der Schritt des Einbauens der Störstelle des ersten Leitfähigkeitstyps in das Substrat den Einbau der Störstelle des ersten Leitfähigkeitstyps durch die fünfte Zone (39; 65) umfaßt.

9. Verfahren nach einem der vorhergehenden Ansprüche, wobei die obere Zone des Substrats einen unteren Abschnitt (12) aufweist, der schwerer dotiert ist als ein oberer Abschnitt (15).

10. Verfahren nach Anspruch 9, wobei sich die dritte und die vierte Zone in den oberen Abschnitt (15) des Substrats und nicht in den unteren Abschnitt (12) erstrecken.

11. Verfahren nach Anspruch 9 oder 10, wobei vor dem Schritt des Bildens der ersten Störstellenmaske eine Störstelle des ersten Leitfähigkeitstyps in eine sechste Zone des Substrats eingebaut wird, die von der dritten und vierten Zone getrennt ist, um eine Verbindung (53) mit dem unteren Abschnitt (12) des Substrats zu bilden.

12. Verfahren nach einem der Ansprüche 1 bis 8, das vor dem Schritt des Bildens der ersten Isolationsschicht (18) die folgenden Schritte umfaßt:
Einbauen einer ausgewählten Störstelle des ersten Leitfähigkeitstyps in eine Siliziumscheibe des entgegengesetzten Leitfähigkeitstyps zur Bildung einer eingebetteten Schicht (12); und
Auftragen einer Siliziumschicht (15) des ersten Leitfähigkeitstyps auf die Siliziumsscheibe zur Bildung des Substrats.

13. Verfahren nach Anspruch 12, wobei die Siliziumschicht (15) beim ersten Leitfähigkeitstyp weniger stark dotiert ist, als die eingebettete Schicht (12).

14. Verfahren nach Anspruch 12 oder 13, wobei der Schritt des Einbauens einer ausgewählten Störstelle des ersten Leitfähigkeitstyps weiterhin den Einbau der ausgewählten Störstelle in die gesamte Siliziumscheibe unter der ersten, dritten und vierten Zone umfaßt.

15. Verfahren nach Anspruch 14, umfassend den Schritt des Einbauens einer zusätzlichen Störstelle des ersten Leitfähigkeitstyps in die Siliziumscheibe wenigstens unter der ersten und der dritten Zone.

16. Verfahren nach Anspruch 15, wobei die zusätzliche Störstelle des ersten Leitfähigkeitstyps eine größere Siliziumdiffusivität hat, als die gewählte Störstelle.

17. Verfahren nach Anspruch 16, wobei die gewählte Störstelle Arsen und die zusätzliche Störstelle Phosphor enthält.

18. Verfahren nach einem der vorhergehenden Ansprüche, wobei das Substrat Silizium, die erste Isolationsschicht (18) Siliziumdioxid und die erste Störstellenmaske (21) Siliziumnitrid aufweist.

19. Verfahren nach einem der vorhergehenden Ansprüche, wobei der erste Leitfähigkeitstyp P ist.

20. Verfahren zur Herstellung einer selbstjustierten, steuerbaren, lateralen Siliziumgleichrichterschaltung, umfassend die folgenden Schritte:
Bilden einer ersten Schicht (18) auf einem Halbleitersubstrat mit einer darunterliegenden Zone (10) des Leitfähigkeitstyps P und einer darüberliegenden Zone (12, 15) des Leitfähigkeitstyps N;
Bilden einer Maskierungsschicht (21) auf der ersten Schicht über einer ersten Zone des Substrats;
Entfernen von wenigstens einem Teil der Schicht (21) von einer zweiten und einer dritten Zone des Substrats, wobei die zweite und dritte Zone durch die erste Zone getrennt sind; und
Bilden von elektrischen Verbindungen (43, 41, 45) mit der zweiten Zone und einer dritten Zone und einer vierten Zone,
gekennzeichnet durch das Einbauen einer Störstelle des Leitfähigkeitstyps P in das Substrat über der dritten Zone und einer die zweiten Zone umgebenden vierten Zone;
Einbauen einer Störstelle des Leitfähigkeitstyps N in das Substrat über der zweiten Zone.

21. Verfahren nach einem der vorhergehenden Ansprüche beim Einsatz für die Herstellung einer Halbleiterstruktur für eine statische Schreib-Lese-Speicherzelle.

## Revendications

1. Procédé de fabrication d'une structure de semi-conducteur latéral à redresseur au silicium commandé comprenant les stades d'utilisation d'un substrat semi-conducteur comportant une région supérieure (12, 15) d'un premier type de conductivité placée sur une région inférieure (10) d'un type de conductivité opposé;
de formation d'une première couche isolante (18) de première épaisseur sur un substrat semi-conducteur;
de formation d'un premier masque d'impureté (21) sur la première couche isolante au-dessus d'une première région du substrat;
d'élimination d'au moins une partie de la première couche isolante (18) placée sur une seconde région du substrat à côté de la première région;
d'application de connexions électriques (43, 41, 45) sur la seconde région et sur une troisième région et sur une quatrième région,
caractérisé en ce qu'une impureté d'un type de conductivité opposé est introduite dans le substrat uniquement dans des régions non recouvertes par le masque d'impureté (21) pour former une troisième et une quatrième région (33; 62) spatialement séparées l'une de l'autre par une impureté du premier type de conductivité puis
d'introduction d'une impureté du premier type de conductivité dans le substrat à travers la seconde région (38; 63).

2. Procédé selon la revendication 1 où la troisième région (33; 62) est placée de sorte à entourer la seconde région (38; 63).

3. Procédé selon la revendication 2 où le stade d'élimination consiste à éliminer au moins une partie de la première épaisseur de la première couche isolante (18) au-dessus d'une partie sélectionnée de la troisième région.

4. Procédé selon la revendication 3 où le stade d'élimination comporte l'élimination de toute la première couche isolante (18) au-dessus de la seconde région et de toute la première couche isolante (10) au-dessus de la partie sélectionnée de la troisième région.

5. Procédé selon la revendication 4 où le stade d'élimination comporte, après le stade d'élimination de toute la première couche isolante (18), le stade de formation d'un matériau isolant supplémentaire au-dessus de la seconde région et de la partie sélectionnée de la troisième région.

6. Procédé selon la revendication 5 où le matériau isolant supplémentaire offre une seconde épaisseur inférieure à la première épaisseur.

7. Procédé selon toute revendication précédente où le stade d'élimination comporte l'élimination au moins d'une partie de la première épaisseur de la première couche isolante au-dessus d'une cinquième région, la cinquième région (39; 65) étant éloignée de la seconde région (38) mais aussi entourée de la troisième région.

8. Procédé selon la revendication 7 où le stade d'introduction d'une impureté de premier type de conductivité dans le substrat comporte l'introduction de l'impureté de premier type de conductivité à travers la cinquième région (39; 65).

9. Procédé selon toute revendication précédente où la région supérieure du substrat comporte une portion inférieure (12) plus lourdement dopée qu'une portion supérieure (15).

10. Procédé selon la revendication 9 où les troisième et quatrième régions s'étendent dans la portion supérieure (15) du substrat et pas dans la portion inférieure (12).

11. Procédé selon la revendication 9 ou 10 où avant le stade de formation du premier masque d'impureté, une impureté du premier type de conductivité est introduite dans une sixième région du substrat séparée tant de la troisième que de la quatrième région pour former une connexion (53) à la portion inférieure (12) du substrat.

12. Procédé selon l'une quelconque des revendications 1-8 comprenant, avant le stade de formation de la première couche isolante (18), les stades:
d'introduction d'une impureté sélectionnée du premier type de conductivité dans une tranche de silicium du type de conductivité opposé pour former une couche enterrée (12); et
de dépôt d'une couche de silicium (15) du premier type de conductivité sur la tranche de silicium pour ainsi former le substrat.

13. Procédé selon la revendication 12 où la couche de silicium (15) est moins fortement dopée avec un premier type de conductivité que la couche enterrée (12).

14. Procédé selon la revendication 12 ou 13 où le stade d'introduction d'une impureté sélectionnée du premier type de conductivité comporte de plus l'introduction de l'impureté sélectionnée dans toute la tranche de silicium sous les première, troisième et quatrième régions.

15. Procédé selon la revendication 14 comprenant le stade d'introduction d'une impureté supplémentaire du premier type de conductivité dans la tranche de silicium sous au moins les première et troisième régions.

16. Procédé selon la revendication 15 où l'impureté supplémentaire de premier type de conductivité offre un plus grand pouvoir de diffusion dans le silicium que l'impureté sélectionnée.

17. Procédé selon la revendication 16 où l'impureté sélectionnée comprend de l'arsenic et l'impureté supplémentaire contient du phosphore.

18. Procédé selon toute revendication précédente où le substrat contient du silicium, la première couche isolante (18) comprend du dioxyde de silicium et le premier masque d'impureté (21) comprend de l'azoture de silicium.

19. Procédé selon toute revendication précédente où le premier type de conductivité est P.

20. Procédé de fabrication d'un circuit latéral auto-aligné à redresseur au silicium commandé comprenant les stades
de formation d'une première couche isolante (18) sur un substrat semi-conducteur qui comporte une région sous-jacente (10) de type de conductivité P et une région sus-jacente (12, 15) de type de conductivité N ;
de formation d'une couche de masquage (21) sur la première couche au-dessus d'une première région du substrat;
d'élimination d'au moins une partie de la couche (21) d'au-dessus une seconde et une troisième région du substrat, les seconde et troisième régions étant séparées par la première région; et
de formation de connexions électriques (43, 41, 45) à la seconde région et à une troisième région et à une quatrième région,
caractérisé par l'introduction d'une impureté de type de conductivité P dans le substrat au-dessus de la troisième région et d'une quatrième région entourant la seconde région;
d'introduction d'une impureté du type de conductivité N dans le substrat au-dessus de la seconde région.

21. Procédé selon toute revendication précédente lors de son emploi pour la fabrication d'une structure de semi-conducteur pour une cellule de mémoire RAM statique.
